## Europäisches Patentamt

**European Patent Office**

**Office européen des brevets**

(11) Numéro de publication: **0 068 945**
**B1**

(12)
## FASCICULE DE BREVET EUROPEEN

(45) Date de publication du fascicule du brevet:
**23.01.85**

(21) Numéro de dépôt: **82401036.7**

(22) Date de dépôt: **08.06.82**

(51) Int. Cl.⁴: **H 01 L 29/72**

(54) **Transistor bipolaire à commande par effet de champ au moyen d'une grille isolée.**

(30) Priorité: **16.06.81 FR 8111835**

(43) Date de publication de la demande:
**05.01.83 Bulletin 83/1**

(45) Mention de la délivrance du brevet:
**23.01.85 Bulletin 85/4**

(84) Etats contractants désignés:
**DE FR GB IT NL**

(56) Documents cités:
**US - A - 4 032 961**

**IEEE SPECTRUM, vol.18, no.1, janvier 1981, New York (US), "Solid state III. Discrete devices", pages 64-65 IBM TECHNICAL DISCLOSURE BULLETIN, vol.22, no.12, mai 1980, New York (US), R.R. GARNACHE et al.: "Impedance gain control for bipolar device", pages 5291-5293 SOLID-STATE TECHNOLOGY, vol.11, no.3, mars 1968, Washington (US), J. LELAND SEELY: "A survey of field effect structures", pages 36-40**

(73) Titulaire: **THOMSON-CSF, 173, Boulevard Haussmann, F-75379 Paris Cedex 08 (FR)**

(72) Inventeur: **Descamps, Bernard, THOMSON-CSF SCPI 173, bld Haussmann, F-75379 Paris Cedex 08 (FR)**

(74) Mandataire: **Guérin, Michel et al, THOMSON-CSF SCPI 173, Bld Haussmann, F-75379 Paris Cédex 08 (FR)**

BUNDESDRUCKEREI BERLIN

## Description

La présente invention concerne les transistors de puissante.

On cherche à réaliser des transistors capables de laisser passer un courant élevé et de supporter des tensions de claquage élevées, mais n'exigeant qu'une faible puissance de commande pour passer de l'état bloqué à l'état conducteur et inversement. Les ordres de grandeur qu'on cherche à atteindre sont de 400 volts pour la tension de claquage et une dizaine d'ampères pour le courant (pour une pastille de silicium d'une dizaine de millimètres carrés).

On a déjà proposé d'utiliser des transistors à effet de champ verticaux (DMOS ou VMOS), mais leur inconvénient majeur est leur résistance imortante à l'état conducteur, notamment à cause du fait que la conduction dans le drain est assurée par des porteurs majoritaires exclusivement.

Les structures qui ont pu être essayées jusqu'à présent et qui mettent en oeuvre une conduction simultanée par porteurs majoritaires et minoritaires, tout en utilisant une commande par effet de champ à partir d'une grille isolée, ne sont pas autre chose que des thyristors, c'est-à-dire qu'elles peuvent être rendues passantes avec une très faible puissance de commande mais ne plus être bloquées autrement que par une annulation du courant dans le dispositif (article Solid State Technology Vol 11 N° Mars 1968 pages 36—40).

La présente invention propose une structure semiconductrice qui assure le passage d'un courant élevé avec une conduction par porteurs majoritaires et minoritaires, donc avec une faible résistance interne, qui est commandée par effet de champ au moyen d'une grille isolée donc avec une très faible puissance de commande, et qui ne présente pas un fonctionnement en thyristor mais en transistor, c'est-à-dire que la mise en conduction aussi bien que le blocage peuvent se faire à partir de l'électrode de commande.

La structure de la présente invention comprend essentiellement un transistor bipolaire vertical de puissance dont l'émetteur et le collecteur constituent, avec leurs contacts respectifs, les électrodes principales de la structure, et dont la base est reliée au drain d'un transistor à effet de champ à grille isolée (MOS), de sorte que la mise en conduction du transistor MOS engendre, pour le transistor bipolaire, un courant de base qui est amplifié et provoque le passage d'un courant important entre l'émetteur et le collecteur.

L'émetteur est le substrat semiconducteur sur lequel est formée la structure; il est dopé avec une impureté d'un premier type de conductivité. Un contact d'émetteur est réalisé par métallisation de la face inférieure du substrat.

La base est constituée dans une couche épitaxiale du type de conductivité opposé, peu dopée, recouvrant le substrat.

Le collecteur est constitué par une zone dopée à partir de la surface, du premier type de conductivité. Cette zone est fortement dopée, au moins en son centre; elle possède une large surface et est recouverte sur la majeure partie de cette surface d'une métallisation constituant un contact de collecteur. On cherche à avoir ainsi une faible résistance de la zone de collecteur, non seulement pour assurer une faible résistance du transistor à l'état passant, ce qui est un des buts à atteindre, mais aussi pour aider à empêcher, d'une manière que l'on expliquera plus loin, qu'il ne se produise un effet thyristor parasite dans la succession de zones de types de conductivité alternés.

La drain du transistor MOS est constitué par une partie de couche épitaxiale du second type de conductivité qui affleure à la surface de la plaquette de semiconducteur en dehors de la zone de collecteur. Il n'y a pas d'électrode de drain.

La source est constituée par une zone dopée à partir de la surface avec une impureté du deuxième type, à l'intérieur de la zone de collecteur du premier type de conductivité, et le long du bord de cette dernière; l'intervalle entre la zone de source et le bord périphérique de la zone de collecteur constitue, là où il affleure à la surface de la couche épitaxiale, une région de canal pour le transistor MOS. Cette région de canal est recouverte d'une couche isolante mince, elle-même recouverte d'une couche conductrice qui est la grille de commande du transistor MOS, constituant en même temps 'électrode de commande de la structure selon l'invention.

La zone de source est indirectement connetée électriquement à la métallisation de collecteur par l'intermédiaire d'une zone résistive d'accès à la source, dont une extrémité est en contact électrique avec la source et l'autre avec la métallisation de collecteur. Cette zone résistive d'accès à la source est en silicium monocristallin ou polycristallin. Elle a pour rôle de provoquer une chute de tension, essentiellement proportionnelle au courant de drain, entre l'électrode de collecteur et la zone de source, et par là de contribuer à empêcher un déclenchement de thyristor parasite, d'une manière que l'on expliquera plus loin.

Ainsi, la forte réduction de la résistance interne de la zone de collecteur (par son dopage élevé et sa grande surface), et l'introduction d'une résistance d'acces à la source de valeur suffisante, coopèrent pour empêcher que le transistor bipolaire commandé par effet de champ ne se transforme en thyristor pour les courants élevés.

Dans la structure selon l'invention, la conduction est assurée aussi bien par des porteurs majoritaires que par des porteurs minoritaires puisque le courant principal est le courant de collecteur d'un transistor bipolaire.

La tension de claquage entre collecteur et émetteur est élevée car, dans le sens direct c'est la tension de claquage entre drain et source d'un transistor MOS, et dans le sens inverse c'est la tension de claquage à travers la base peu dopée d'un transistor bipolaire vertical.

Le courant de commande est extrêmement faible puisque la commande s'effectue à travers la grille isolée du transistor MOS.

Pour réaliser la zone résistive d'accès à la source, on peut prévoir à la surface du silicium monocristallin, dans la région de collecteur, des régions étroites dopées avec une impureté de même type que la source, ces régions étroites s'étendant depuis la zone de source proprement dite (qui longe la région de canal), dans une direction transversale au bord du canal, vers l'intérieur de la région de collecteur; la métallisation de collecteur, en contact avec la majeure partie de la région de collecteur du premier type de conductivité, vient aussi en contact avec les régions étroites du second type, mais seulement en des endroits écartés de la région de source proprement dite qui longe le bord du canal.

On peut aussi réaliser la zone résistive d'accès à la source par une couche de silicium polycristallin déposée sur une couche isolante et reliée électriquement d'une part directement à la métallisation du contact de collecteur et d'autre part, directement ou par l'intermédiaire d'un dépôt métallique, à la région de source.

D'autres caractéristiques et avantages de l'invention apparaîtront à la lecture de la description détaillée qui suit et qui est faite en référence aux dessins annexés dans lesquels:

— la figure 1 est une coupe de la structure de l'invention, expliquant l'essentiel du principe de celle-ci;
— la figure 2 est une vue de dessus d'un premier mode de réalisation correspondant à la figure 1;
— la figure 3 est une coupe selon la ligne B-B de la figure 2;
— la figure 4 est une perspective coupée montrant un deuxième mode de réalisation de l'invention.

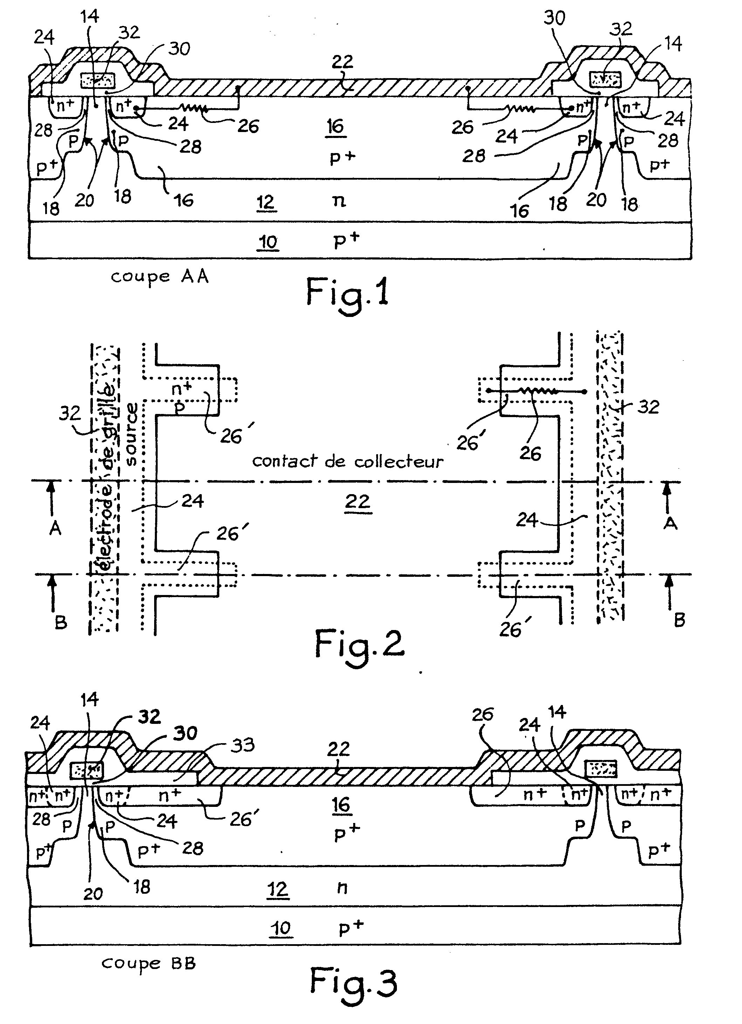

La structure de transistor bipolaire commandé par effet de champ, selon l'invention, est représentée en coupe à la figure 1.

Il s'agit de transistors bipolaires de puissance, et on comprendra que la structure peut comprendre tout un réseau symétrique de cellules en parallèle comportant chacune un élément de transistor bipolaire et un élément de transistor MOS qui le commande. On s'attachera à la description d'une seule cellule, mais on voit déjà sur la figure 1 la symétrie qui existe entre deux cellules voisines.

Le transistor bipolaire est formé dans une plaquette de silicium qui comprend un substrat 10 d'un premier type de conductivité (p dans l'exemple représenté). Le dopage est relativement élevé et est indiqué par le symbole p$^+$ sur les figures.

Ce substrat est recouvert uniformément d'une couche épitaxiale 12 de silicium, de type de conductivité opposé (n), relativement peu dopée.

Dans cette couche épitaxiale 12 sont formées à partir de la surface, par dopage, des régions de type p qui occupent la majeure partie de la surface de la plaquette et qui laissent entre elles des intervalles étroits 14 où la couche épitaxiale 12 avec son dopage initial n affleure à la surface du silicium.

Sur les figures, les dimensions verticales ne correspondent pas à une échelle réelle, mais les dimensions latérales sont à l'échelle de façon qu'on voie bien que la majeure partie de la surface de la couche épitaxiale 12 a subi un dopage de type p. A titre d'exemple la dimension des régions p est d'environ 100 microns et les intervalles 14 peuvent être d'une dizaine de microns.

En réalité, il est préférable que le dopage de type p ait été effectué en deux étapes, la première consistant en un dopage de faible profondeur et faible concentration (indiqué par p sur la figure 1), par diffusion ou implantation ionique et la deuxième consistant en un nouveau dopage, de plus grande profondeur et de concentration élevée (indiqué par p$^+$), effectué par exemple par diffusion, mais dans une surface légèrement plus petite que la région correspondant au premier dopage, de sorte que finalement la majeure partie de la surface de la couche épitaxiale a subi un dopage élevé et profond (p$^+$), mais qu'il subsiste autour une zone de même type de conductivité, moins dopée et moins profonde. La zone centrale de type p$^+$ est désignée par la référence 16 et la zone p par 18. Le bord périphérique extérieur de la zone p 18, qui est adjacent à la partie affleurante 14 de la couche épitaxiale 12, est désigné par la référence 20.

Le substrat 10 de type p$^+$ constitue la zone d'émetteur du transistor bipolaire qui est de type PNP. La face inférieure du substrat peut être métallisée pour constituer un contact d'émetteur. On peut envisager aussi un puits d'accès de type p$^+$ reliant la surface au substrat si l'on souhaite prendre un contact d'émetteur par la partie supérieure de la plaquette.

La région de base du transistor bipolaire est la partie de la couche épitaxiale 12 qui se situe au-dessous de la zone 16 de type p$^+$. Il n'y a pas de contact de base.

La zone 16 de type p$^+$ constitue la zone de collecteur du transistor PNP. Sur la plus grande partie de sa surface supérieure (qui occupe, on le rappelle, la majeure partie de la surface du silicium), est déposée une couche conductrice 22 qui forme le contact de collecteur (par exemple en aluminium).

Les zones 14, parties de couche épitaxiale de type n qui affleurent à la surface le long des bords des zones 18 de type p, constituent les drains de transistors à effet de champ (MOS à canal N). Il n'y a pas de contact de drain de même qu'il n'y a pas de contact de base, et on voit que base et drain sont tous deux constitués dans la couche épitaxiale 12 de type n.

Des régions 24 fortement dopées de type n+ sont formées à partir de la surface dans les régions 16 et 18 qui ont été préalablement dopées avec une impureté de type p. Il s'agit de régions de source 24 du transistor à effet de champ; elles s'étendent longitudinalement (sur la figure 1, c'est dans une direction perpendiculaire au plan du dessin) le long du bord 20 des régions 18 de type p, en laissant toutefois un intervalle étroit de type p entre elles et ce bord. Cet intervalle étroit comporte une partie 28 qui affleure à la surface du silicium et qui constitue la région de canal du transistor à effet de champ. Les régions de source 24 de type n+ ont une profondeur moindre que les régions 18 de type p.

La partie affleurante 28 des régions de canal est recouverte d'une couche isolante mince 30 (de préférence de l'oxyde de silicium thermique) elle-même recouverte d'une région de grille conductrice 32 en aluminium ou en silicium polycristallin dopé.

En pratique, compte tenu du fait que l'intervalle 14 entre les différentes régions 18 de type p est étroit, la couche isolante 30 et la grille conductrice 32 recouvrent tout cet intervalle et les deux régions de canal 28 qui le bordent. On aboutit ainsi à une électrode de commande commune 32 de faible largeur qui s'étend au-dessus de l'intervalle 14 et des régions 28 immédiatement adjacentes; cette électrode, en contrôlant les régions de canal 28 qui se situent de part et d'autre de l'intervalle 14, commande la conduction des deux transistors bipolaires correspondant aux deux régions, 16, 18 séparées par l'intervalle 14.

Enfin, une chose n'apparaît pas sur la figure 1, il s'agit d'une liaison résistive, symboliquement représentée par une résistance 26, entre chaque région de source 24 et le contact métallique de collecteur 22. On comprendra en examinant les figures 2 et 3 pourquoi cette liaison résistive 26 n'apparaît pas physiquement sur la figure 1 qui est une coupe selon la ligne A-A de la vue de dessus représentée à la figure 2.

Le fonctionnement de la structure selon l'invention est le suivant: une différence de potentiel positive est appliquée entre le collecteur et l'émetteur comme dans tout transistor bipolaire PNP.

En l'absence d'application d'une tension de commande sur l'électrode de commande 32 du transistor MOS, aucun canal ne se forme dans les zones 28 et le transistor MOS est bloqué. La jonction collecteur-base est polarisée en inverse. Aucun trajet de courant n'est possible dans la base. Le potentiel de la région de base reste donc sensiblement au niveau du potentiel d'émetteur.

La structure ne laisse passer aucun courant entre l'émetteur et le collecteur.

Lorsqu'un potentiel positif suffisant (au-dessus de la tension de seuil du transistor MOS) est appliqué à l'électrode de commande 32, un canal se crée dans les zones 28, reliant électriquement le drain à la source, de sorte que le potentiel du drain, qui était initialement très proche de celui de l'émetteur, chute pour se rapprocher de celui de la source (qui est sensiblement celui du collecteur).

Le potentiel de la base chute donc aussi puisque base et drain sont constitués par la même région de type n. La jonction émetteur-base devient polarisée en direct de sorte qu'il y a injection de porteurs de l'émetteur dans la base; ces porteurs sont accélérés vers le collecteur.

Le transistor bipolaire devient conducteur et transmet un courant important entre son émetteur et son collecteur.

Lorsque la tension de commande sur l'électrode 32 est supprimée, le potentiel du drain et de la base remontent puisqu'il n'y a plus de possibilité d'écoulement du courant de base, et le transistor bipolaire se bloque.

Le transistor bipolaire est destiné à passer de fortes densités de courant. C'est pourquoi on prévoit non seulement une large surface de la région 16 de collecteur, mais aussi un large contact métallique qui occupe presque toute la surface de la région 16; de plus, cette région 16 est fortement dopée.

Cependant, malgré cela, il subsiste une certaine résistance interne du collecteur et cette résistance crée une chute de tension qui, lorsque le courant est élevé, peut dépasser la tension de mise en conduction d'une jonction p-n. Si la région de source était connectée directement au potentiel du contact de collecteur, cette chute de tension pourrait rendre conductrice la jonction entre la source et la région 18 de type p. Il en résulterait un accroissement du courant de base et donc un accroissement du courant de collecteur; le processus est divergent et on assisterait à l'établissement d'un courant de collecteur maximal que l'on ne peut plus arrêter. On se trouve en présence d'un phénomène d'autopolarisation du transistor bipolaire PNP. On peut aussi expliquer ce phénomène par le fait que la chute de tension dans le collecteur déclenche la conduction d'un thyristor parasite qui serait constitué par la succession des régions 24 (source), 16 (collecteur), 12 (base), et 10 (émetteur), de types de conductivité alternés; bien que de surface utile faible (surface correspondant à celle de la source 24), ce thyristor maintient en conduction le transistor bipolaire en laissant passer dans la base un courant important qui ne peut être arrêté une fois le thyristor déclenché et qui est amplifié par le transistor.

Pour empêcher ce phénomène indésirable, non seulement on diminue autant que possible la résistance interne du collecteur par les moyens déjà indiqués, mais encore on prévoit que les régions de source 24 ne sont pas directement connectées au contact de collecteur mais qu'elles sont reliées à ce contact par l'intermédiaire de zones résistives d'accès à la source, qui ont été figurées symboliquement par les résistances 26. Lorsque le courant collecteur augmente par suite d'une augmentation du courant de base donc du courant drain du transistor MOS, une chute de tension se produit dans la zone résistive parcourue par le courant drain, de sorte que la chute de tension aux bornes de la jonction source-canal n'est plus égale à la chute de tension dans la région de collecteur mais est réduite de la valeur de la chute de tension dans la résistance 26.

Comme ces chutes de tension varient sensiblement parallèlement, il suffit de choisir la résistance 26 suffisamment importante pour éviter la mise en conduction de la jonction pour le courant maximum susceptible de traverser le transistor.

Pratiquement, il faudra que la résistance 26 soit supérieure au produit de la résistance interne du collecteur par le gain en courant du transistor bipolaire.

Une résistance de quelques ohms ou quelques dizaines d'ohms est tout à fait appropriée pour les transistors de puissance considérés.

La figure 2 montre, en combinaison avec la figure 3, comment on peut réaliser les zones résistives d'accès à la source: ces zones sont des zones 26' de type n+ formées à l'intérieur de la région de collecteur 16, en même temps et de la même manière que les régions de source. Elles constituent essentiellement des avancées transversales étroites qui partent d'une région de source 24 (qui, elle, s'étend longitudinalement en longeant un bord de région de type p); ces avancées transversales étroites sont dirigées vers l'intérieur des zones p+ (16). Le contact de collecteur qui revouvre la majeure partie de la surface des régions p+ (16) vient en contact aussi avec l'extrémité (écartée de la source) des zones 26' d'accès à la source, mais il ne vient pas en contact avec les régions de source 24. Pour cela, le contact métallique de collecteur est gravé selon une forme échancrée au niveau de chaque avancée latérale constituant une zone 26', la profondeur de l'échancrure étant évidemment moindre que la longueur de l'avancée et sa largeur étant plus grande que la largeur de l'avancée, pour que la métallisation de collecteur vienne en contact uniquement avec l'extrémité des zones 26' sans venir sur d'autres parties de silicium de type n+.

Le rapport entre la longueur et la largeur des zones 26' règle la valeur de la résistance constituée. Si la résistivité de la zone de type n+ est de quelques ohms par carré, ce rapport peut être de quelques unités.

La figure 3, qui est une coupe tout à fait analogue à la figure 1 mais faite au niveau de la ligne B-B de la figure 2 donc au niveau d'une zone 26', montre la présence des zones d'accès résistives 26' qui n'apparaissaient pas sur la coupe de la figure 1. On notera que c'est la zone de contact proprement dite de la métallisation avec le silicium qui présente des échancrures. Sur la figure 3 les échancrures ne sont pas des interruptions dans la métallisation mais des régions où la métallisation est isolée du silicium par une couche d'oxyde 33 ayant la forme des échancrures de la figure 2.

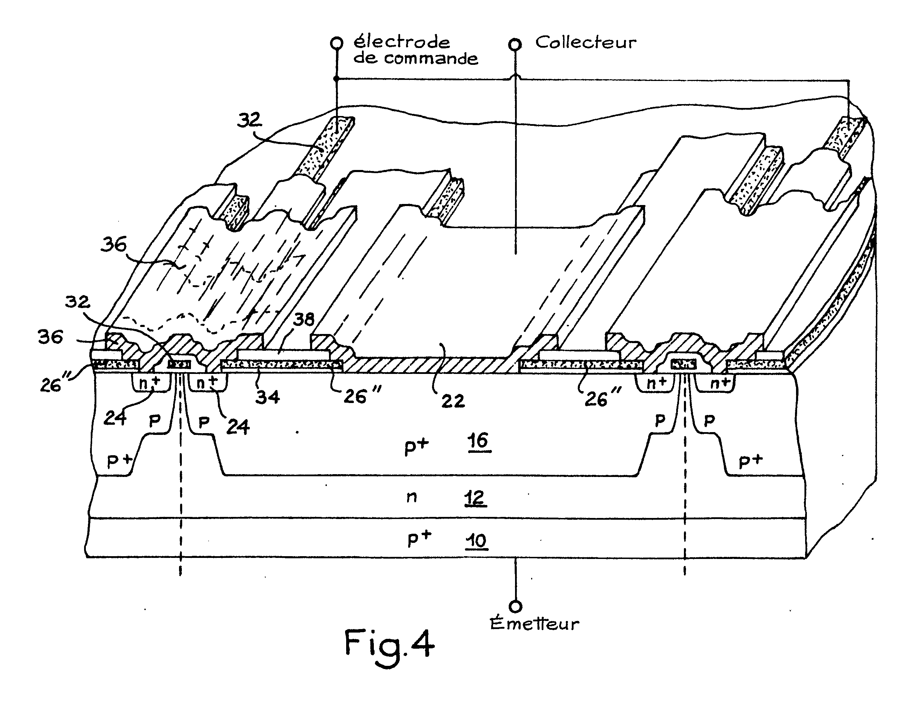

La figure 4 montre une autre manière de réaliser les liaisons résistives 26 d'accès à la source.

La structure de base est exactement celle qui a été décrite en référence à la figure 1 pour ce qui concerne les régions différemment dopées dans le substrat et la couche épitaxiale de silicium monocristallin. De même, la couche isolante mince et la grille conductrice qui la recouvre sont les mêmes. Mais, la liaison résistive 26 est constituée par une couche de silicium polycristallin 26" qui peut d'ailleurs être déposée en même temps que la grille de commande 32 lorsque celle-ci est en silicium polycristallin. Cette couche 26" est déposée sur une couche d'oxyde de silicium 34 qui l'isole de la région p+. Elle est mise en contact d'un côté avec la région de source 24, soit directement si la couche d'oxyde 34 est interrompue au-dessus de la région de source et si le silicium polycristallin est déposé et conservé au-dessus de la région de source, soit indirectement comme cela est représenté sur la figure 4 grâce à une partie de couche métallique 36 qui recouvre à la fois la région de source dépourvue d'oxyde superficiel et une extrémité de la couche de silicium polycristallin 26" également dépourvue d'oxyde superficiel. De l'autre côté, la couche 26" est en contact avec la métallisation de collecteur 22 qui recouvre son extrémité comme elle recouvre la région 16 de type p+.

Lors de la fabrication, on prévoit de préférence que le silicium polycristallin déposé est gravé puis recouvert d'oxyde de protection et que cet oxyde est gravé pour dénuder les surfaces où le métal doit être ultérieurement déposé. Il subsiste ainsi au-dessus de la zone 26", en dehors des points où elle est en contact avec le métal, une couche d'oxyde 38.

Le silicium polycristallin peut être dopé avec une impureté de type n, soit »in situ« c'est-à-dire au moment du dépôt, soit après. Sa résistivité peut être de l'ordre de 20 ohms par carré (plus élevée donc que celle du silicium monocristallin fortement dopé de type n+). On peut prévoir que la couche de silicium polycristallin 26", servant de liaison résistive entre le contact de collecteur et la région de source 24, s'étend sous forme d'une bande continue longeant la région de source 24 (comme à la figure 4), ou bien qu'elle se présente sous forme de bras transversaux espacés les uns des autres, partant chacun de la région de source et allant vers le centre de la région de collecteur; le contact de collecteur peut alors s'étendre entre les bras de silicium polycristallin donc sur une plus grande surface, avec une forme échancrée comme à la figure 2.

On a ainsi décrit une structure semiconductrice qui, par ses propriétés comme par sa constitution, peut être appelée transistor bipolaire (car la conduction principale s'effectue par porteurs majoritaires et minoritaires) à commande par effet de champ, ou même plus précisément à commande par grille isolée.

Le transistor bipolaire qui a été décrit est un transistor PNP. L'électrode de commande doit recevoir, pour réaliser la mise en conduction, un potentiel positif par rapport au collecteur, supérieur à un seuil déterminé.

En inversant tous les types de conductivité et les signes des potentiels appliqués, on réaliserait de même un transistor NPN qui serait mis en conduction par un potentiel suffisamment inférieur au potentiel du collecteur et bloqué par un potentiel proche de celui du collecteur.

## Revendications

1. Structure semiconductrice du type transistor bipolaire de puissance à commande de conduction et de blocage par la grille isolée d'un transistor à effet de champ comportant une région de source, de drain et de canal, caractérisé en ce qu'elle comprend:

— un substrat semiconducteur (10) dopé avec une impureté d'un premier type de conductivité, constituant une région d'émetteur pour un transistor bipolaire vertical formé dans la structure,
— un contact d'émetteur relié électriquement au substrat (10),
— un couche épitaxiale (12), peu dopée, avec une impureté d'un deuxième type de conductivité opposé au premier, recouvrant le substrat et constituant une région de base du transistor bipolaire,
— une région de collecteur (16, 18), du premier type de conductivité, fortement dopée à partir de la surface de la couche épitaxiale sur sa majeure partie (16), bordée par une région (14) constituant le drain où affleure la couche épitaxiale du second type de conductivité, la région de collecteur étant recouverte sur la majeure partie de sa surface par un contact de collecteur (22),
— une région de source (24), constituée par une zone dopée à partir de la surface de la couche épitaxiale (12) avec une impureté du deuxième type, cette zone étant incluse à l'intérieur de la région de collecteur (16, 18) et longeant un bord (20) de cette dernière en laissant un intervalle (28) entre elle et ce bord qui constitue la région de canal,
— une couche isolante mince (30) recouvrant cet intervalle (28) et une couche conductrice (32) recouvrant cette couche isolante mince pour constituer la grille de commande de la structure,
— une zone résistive (26, 26', 26'') d'accès à la source reliée d'un côté à la région de source (24) et de l'autre au contact de collecteur (22), la résistance de cette zone étant suffisamment grande pour empêcher une mise en conduction directe de la jonction constituée entre les régions de source (24) et de collecteur (16, 18) lorsqu'un courant passe dans le collecteur.

2. Structure semiconductrice selon la revendication 1, caractérisé par le fait que la région de collecteur (16) est moins dopée dans l'intervalle (28) entre son bord (20) et la région de source (24) que dans l'intérieur.

3. Structure semiconductrice selon l'une des revendications 1 ou 2, caractérisé par le fait que la zone résistive (26) d'accès à la source est constituée par une ou plusieurs régions (26') de semiconducteur de la couche épitaxiale, dopées avec une impureté de même type que la région de source, en forme d'avancées latérales étroites s'étendant à partir de la région de source (24) et s'avançant vers l'intérieur de la région de collecteur (16), et par le fait que le contact de collecteur (22) vient en contact aussi avec ces avancées latérales étroites, uniquement en des points écartés de la région de source.

4. Structure semiconductrice selon la revendication 3, caractérisé par le fait que le contact de collecteur (22) présente une forme échancrée au niveau de chaque avancée latérale et qu'il s'étend entre les avancées latérales sans venir en contact avec la région de source (24).

5. Structure semiconductrice selon l'une des revendications 1 ou 2, caractérisé par le fait que la zone résistive d'accès à la source est constituée par une bande de silicium polycristallin (26'') déposée sur une couche isolante (34) et venant en contact d'un côté, directement ou par l'intermédiaire d'une métallisation (36), avec la région de source (24), et de l'autre avec le contact de collecteur (22).

6. Structure semiconductrice selon l'une des revendications 1 à 5, caractérisé par le fait que la surface de la structure est subdivisée en plusieurs régions de collecteurs occupant la majeure partie de la surface et séparées les unes des autres par des intervalles étroits (14) où affleure la couche épitaxiale du deuxième type de conductivité, des régions de source (24) en vis à vis, longeant cet intervalle étroit étant formées à l'intérieur des régions de collecteur adjacentes (16), de part et d'autre de l'intervalle étroit, une couche isolante (30) recouvrant l'espace séparant les régions de source en vis à vis et une couche conductrice (32) déposée sur la couche isolante recouvrant également cet espace pour constituer une électrode de commande commune pour les transistors bipolaires correspondant à deux régions de collecteur adjacentes.

## Patentansprüche

1. Halbleiterstruktur vom Typ eines bipolaren Leistungstransistors, dessen Leitungs- und Sperrzustand durch das isolierte Gate eines Feldeffekttransistors gesteuert wird, der ein Sourcegebiet, ein Draingebiet und ein Kanalgebiet umfaßt, dadurch gekennzeichnet, daß sie umfaßt:

— ein Halbleitersubstrat (10), das mit einer Verunreinigung eines ersten Leitungstyps dotiert ist und einen Emitterbereich für einen vertikalen bipolaren Transistor bildet, der in der Struktur gebildet ist,

— einem elektrisch mit dem Substrat (10) verbundenen Emitterkontakt,

— eine epitaktische Schicht (12), die schwach mit einer Verunreinigung eines zweiten, dem ersten entgegengesetzten Leitungstyps dotiert ist und das Substrat bedeckt sowie ein Basisgebiet des bipolaren Transistors bildet,

— ein Kollektorgebiet (16, 18) vom ersten Leitungstyp, das von der Oberfläche der epitaktischen Schicht ausgehend über seinen größten Teil (16) stark dotiert ist und umgeben ist von einem Gebiet (14), welches die Drainelektrode bildet, wo die epitaktische Schicht des zweiten Leitungstyps bündig anschließt, wobei das Kollektorgebiet auf dem größten Teil seiner Oberfläche durch einen Kollektorkontakt (22) bedeckt ist,

— ein Sourcegebiet (24), welches durch eine Zone gebildet ist, die ausgehend von der Oberfläche der epitaktischen Schicht (12) mit einer Verunreinigung des zweiten Typs dotiert ist, wobei diese Zone im Inneren des Kollektorgebiets (16, 18) enthalten ist und sich längs eines Randes (20) desselben erstreckt, indem es einen Zwischenraum (28) zwischen sich und diesem Rand freiläßt, durch welchen das Kanalgebiet gebildet ist,

— eine dünne Isolierschicht (30), welche diesen Zwischenraum (28) bedeckt, und eine leitende Schicht (32), welche diese dünne Isolierschicht bedeckt, um das Steuergate der Struktur zu bilden,

— eine resistive Zone (26, 26', 26'') für den Zugang zu der Sourceelektrode, welche auf einer Seite an das Sourcegebiet (24) und auf der anderen Seite an den Kollektorkontakt (22) angeschlossen ist, wobei der Widerstand dieser Zone ausreichend groß ist, um eine direkte Leitendsteuerung des zwischen dem Sourcegebiet (24) und dem Kollektorgebiet (16, 18) gebildeten Überganges zu verhindern, wenn ein Strom im Kollektor fließt.

2. Halbleiterstruktur nach Anspruch 1, dadurch gekennzeichnet, daß das Kollektorgebiet (16) in dem Zwischenraum (28) zwischen seinem Rand (20) und dem Sourcegebiet (24) schwächer dotiert ist als im Inneren.

3. Halbleiterstruktur nach Anspruch 1 oder 2, dadurch gekennzeichnet, daß die resistive Zone (26) für den Zugang zu der Sourceelektrode aus einem oder mehreren Halbleitergebieten (26') der epitaktischen Schicht gebildet ist, welche mit einer Verunreinigung desselben Typs wie das Sourcegebiet dotiert sind und die Form von seitlichen schmalen Fortsätzen haben, welche sich von dem Sourcegebiet (24) aus erstrecken und bis zum Inneren des Kollektorgebiets (16) vordringen, und daß der Kollektorkontakt (22) ferner in Berührung mit diesen seitlichen schmalen Fortsätzen kommt, und zwar nur an Punkten, die von dem Sourcegebiet entfernt sind.

4. Halbleiterstruktur nach Anspruch 3, dadurch gekennzeichnet, daß der Kollektorkontakt (22) eine ausgebuchtete Form im Bereich jedes seitlichen Fortsatzes aufweist und sich zwischen den seitlichen Fortsätzen erstreckt, ohne mit dem Sourcegebiet (24) in Berührung zu kommen.

5. Halbleiterstruktur nach Anspruch 1 oder 2, dadurch gekennzeichnet, daß die resistive Zone für den Zugang zu der Sourceelektrode aus einem polykristallinen Siliciumstreifen (26'') gebildet ist, welcher auf einer Isolierschicht (34) abgelagert ist und auf einer Seite direkt oder über eine Metallisierung (36) mit dem Sourcegebiet (24) und auf der anderen Seite mit dem Kollektorkontakt (22) in Berührung kommt.

6. Halbleiterstruktur nach einem der Ansprüche 1 bis 5, dadurch gekennzeichnet, daß die Oberfläche der Struktur in mehrere Kollektorgebiete unterteilt ist, welche den Hauptteil der Oberfläche einnehmen und voneinander durch schmale Zwischenräume (14) getrennt sind, wobei die epitaktische Schicht des zweiten Leitungstyps einmündet, wobei einander gegenüberliegende Sourcegebiete (24), welche sich längs dieses schmalen Zwischenraumes erstrecken, im Inneren der benachbarten Kollektorgebiete (16) auf beiden Seiten des schmalen Zwischenraumes gebildet sind, eine Isolierschicht (30) den Raum bedeckt, welcher die einander gegenüberliegenden Sourcegebiete trennt, und eine leitende Schicht (32), welche auf der Isolierschicht aufgebracht ist, diesen Raum ebenfalls bedeckt, um eine gemeinsame Steuerelektrode für die bipolaren Transistoren zu bilden, welche zwei benachbarten Kollektorgebieten entsprechen.

**Claims**

1. Semiconductor structure of the type forming a bipolar power transistor with conduction and blocking control through the insulated gate of a field effect transistor comprising source, drain and channel zones, characterized in that it comprises:

— a semiconductor substrate (10) doped with an impurity of a first conductivity type and forming an emitter zone of a vertical bipolar transistor formed within the structure,

— an emitter contact electrically connected to the substrate (10),

— an epitaxial layer (12) having a low doping of an impurity of a second conductivity type opposite to the first, covering the substrate and forming a base zone of the bipolar transistor,

— a collector zone (16, 18) of the first conductivity type which is highly doped from the surface of the epitaxial layer across its major portion (16), bordered by a zone (14) forming the drain where the epitaxial layer of the second conductivity type is joined, the collector zone being covered on the major portion of its surface by a collector contact (22),

— a source zone (24) formed of a zone doped from the surface of the epitaxial layer (12) with an impurity of the second type, this zone being included inside the collector zone (16, 18) and extending along an edge (20) of the latter, leaving an interval between it and this edge to form the channel zone,

— a thin insulating layer (30) covering this interval (28) and a conductive layer (32) covering this thin insulating layer and forming the control gate of the structure,

— a resistive zone (26, 26', 26'') for access to the source and connected on one side to the source zone (24) and on the other side to the collector contact (22), the resistance of this zone being sufficiently high to avoid a direct control into conduction of the junction formed between the source (24) and collector (16, 18) zones when a current flows through the collector.

2. Semiconductor structure according to claim 1, characterized by the fact that the collector zone (16) is less doped in the interval (28) between its edge (20) and the source zone (24) than inside.

3. Semiconductor structure according to any of claims 1 or 2, characterized by the fact that the resistive zone (26) for access to the source is formed of one or a plurality of semiconductor zones (26') of the epitaxial layer which are doped with an impurity of the same type as the source zone, and forming lateral narrow projections extending from the source zone (24) and advancing towards the inside of the collector zone (16), and by the fact that the collector contact (22) also contacts these lateral narrow projections, but only at points remote from the source zone.

4. Semiconductor structure according to claim 3, characterized by the fact that the collector contact (22) has an indented shape about each lateral projection and that it extends between the lateral projections without contacting the source zone (24).

5. Semiconductor structure according to any of claims 1 or 2, characterized by the fact that the resistive zone of access to the source is formed of a polycristalline silicon strip (26'') deposited onto an insulating layer (34) and contacting, on one side, the source zone (24) directly or through a metallization (36), and the collector contact (22) on the other side.

6. Semiconductor structure according to any of claims 1 to 5, characterized by the fact that the surface of the structure is subdivided into a plurality of collector regions occupying the major portion of the surface and separated from each other by narrow intervals (14) where the epitaxial layer of the second conductivity type is joined, facing source zones (24) extending along this narrow interval and being formed inside the adjacent collector zones (16) on both sides of the narrow interval, an insulating layer (30) covering the space separating the facing source zones and a conductive layer (32) being deposited onto the insulating layer and also covering this space for obtaining a common electrode of the bipolar transistors corresponding to two adjacent collector regions.

coupe AA

# Fig.1

électrode de grille

source

contact de collecteur

22

# Fig.2

coupe BB

# Fig.3

électrode
de commande

Collecteur

32

36

32

36

38

26″

n+

n+

34

26″

22

26″

n+

n+

24

P

P

24

P

P

P+

P+ 16

P+

n 12

P+ 10

Émetteur

Fig.4

0 068 945